# EUROPEAN PATENT APPLICATION

(11) **EP 4 447 240 A1**
(43) Date of publication of application: **16.10.2024**
(21) Application number: 22904702.2
(22) Date of filing: 08.12.2022
(51) Int. Cl.: H02B 13/035, G01R 31/327, G01R 15/18, H01F 38/20, G01R 19/25, G01R 19/165, G01R 13/02, G08C 19/00, G08C 17/02

(54) **SYSTEM FOR MONITORING OPERATION CHARACTERISTICS OF POWER SWITCH**

(30) Priority: 09.12.2021 KR 20210175761; 20.04.2022 KR 20220049121
(71) Applicant: Choi, Seung Kil, Suwon-si, Gyeonggi-do 16343 (KR); Choi, Jun Seon, Suwon-si, Gyeonggi-do 16343 (KR)
(72) Inventor: Choi, Seung Kil, Suwon-si, Gyeonggi-do 16343 (KR); Choi, Jun Seon, Suwon-si, Gyeonggi-do 16343 (KR)
(74) Representative: Bureau M.F.J. Bockstael NV
(86) International application number: PCT/KR2022/019981
(87) International publication number: WO 2023/106873

(57) **Abstract**

System for monitoring operation characteristics of a power switch comprises: an electrode sensor which is impregnated as a circular, angular, or pin-type structure in the inside of a conventional insulation material constituting a power switch, or which is separately provided in the form of a separable/detachable electrode sensor module on the outside to as to detect electrostatic voltage induced during position movement of a main contact of the power switch; and an integrated monitoring means which simultaneously operates and displays the switching time, time interval between the first pole and the last pole, stroke, and operating speed of each phase of the power switch on the basis of a voltage value input from the electrode sensor, and which outputs an alarm or a control signal for locking if the operated output values deviate from the set range of operation characteristic limits.

## Description

### [Technical Field]

The present invention relates to a system for monitoring operation characteristics of a power switch, and more particularly, a system for monitoring operation characteristics of a power switch, the system beings capable of monitoring operation characteristics during switching, such as switching, time interval between the first pole and the last pole, stroke, operating speed of each phase of the power switch in real time so as to monitor and control the operation characteristics even from a remote location and detecting a sudden change in operation characteristic value and transmitting an output signal to the outside such that switching and interrupting performance can be ensured in use all the time.

### [Background Art]

Power switches refer to devices that configure, modify, switch, and interrupt electric circuits in order to reliably and efficiently distribute power generated from power plants to consumers, and are largely classified into general switches used for a single purpose and switchgears in which a system includes a circuit configured of several switches and each fulfill complex functions.

The general switches refer to power devices for switching load currents within inspection zones and interrupting power supply in order to perform inspection of lines or loads in power systems which supply electricity, such as transmission systems or distribution systems, and then stably re-supplying the load currents after completing the inspection. The general switches are classified into, depending on purposes of use, circuit breakers (CB), load breaker switches (LBS), automatic transfer switches (ATS), automatic section switches (ASS), automatic load transfer switches (ALTS), earth switches (ES), disconnect switches, and the like.

Depending on insulation techniques, the general switches are classified into gas insulated switchgears (GIS) or solid insulated switchgears. Further, depending on installation locations, the general switches are classified into overhead switches installed on electric poles to switch overhead power lines and underground switches installed inside grounding metal boxes to switch underground power cables. Currently, molded solid insulated switches introduced to prevent global warming are generally used as overhead switches, and SF₆ gas insulated switches and solid insulated switches are currently used together as underground switches, but the switches are expected to be replaced with eco-friendly gas insulated switches in the near future.

In terms of techniques of quenching arcs generated during switching and interrupting currents, the gas insulated switches that use, as arc-quenching mediums, SF₆ gas having excellent arc-quenching performance have been mainly used. However, as the global warming issue due to the use of SF₆ gas has increased, a technique of using a vacuum interrupter has been generally applied after the solid insulated switching technique was developed to solve the global warming issue.

In general, the gas insulated switchgears (GIS) are complex switchgear that not only switches load currents under normal use conditions in power systems, but also safely protects power lines under abnormal conditions such as accidents or short circuits, and each gas insulated switchgear has a configuration in which a circuit breaker (CB), a disconnect switch (DS), an earth switch (ES), a potential transformer (PT), a current transformer (CT), a lighting arrester (LA), a busbar (BUS) are housed in a sealed metallic outer box filled with insulating gas such as SF₆ gas, CO₂, g3, or dry air.

Hardware technologies for the power switches have already reached the completion stage. Recently, focus has been placed on development of eco-friendly technologies such as dry air insulation technologies, epoxy insulation technologies, and large-capacity eco-friendly vacuum interrupter technologies, and application of efficient methods for asset management of power facilities for maintenance and facility replacement considering trouble-free operations of power facilities and economic efficiency has been actively promoted.

As the number of switching operations increases depending on periods in which the power switches are applied to and used in systems, deterioration of electrical components, wear of components of mechanical operation devices, loosening of bolts, damage, or the like results in a change in operation characteristics value during switching, such as switching time, time interval between the first pole and the last pole, stroke, or operating speed of each phase of the power switches. In a case where the power switches have other operation characteristics different from those set in initial installation and do not operate normally, switching and interrupting capability is deteriorated, and this can lead to damage and serious malfunction to power equipment, making it impossible to stably supply power to consumers. Thus, it is very important to monitor and diagnose operation characteristics of power switches during switching.

When integrity of power equipment is evaluated, technical evaluation is performed through regular inspections to determine conditions of the equipment and online preventive diagnoses by using sensors. Main inspection items for the power switches include main circuit characteristics (insulation resistance, contact resistance) of the power equipment and operation characteristics of the switches (a switching time, time interval between the first pole and the last pole, stroke, operating speed), and current preventive diagnosis items include gas condition monitoring (a moisture content, purity, an amount of SO₂ in gas), partial discharge measurement, and the like. However, since the inspections of the power switches are performed in a power cut (no voltage) state, power supply through power lines where corresponding switches are installed has to be stopped, and thus, additional power lines need to be secured to continue supplying power to consumers. In addition, since it is not possible to shut down all power lines at the same time, inspections have to be performed in stages, which increases human and time costs.

Hence, there is an urgent demand for development and application of a monitoring technology that can monitor and diagnose operation characteristics such as the switching time, time interval between the first pole and the last pole, and operating speed of each phase of the power switches in real time by using various types of sensors in a voltage-applied operation state. Operation status data of the power switches collected in real time by sensors can be used to evaluate and analyze integrity of the power switches based on comparative analysis with initial data and collected data. The analyzed data not only can provide information which can be used to determine shutdown and maintenance of equipment to asset owners or managers thereof, but also can be used to issue accurate work instructions to field workers.

### [Citation List]

### [Patent Literature]

[Patent Literature 1]
   Korean Patent Registration No. 10-0996138 (November 17, 2010)
[Patent Literature 2]
   Korean Utility Model Registration No. 20-0446550 (November 2, 2009)
[Patent Literature 3]
   Korean Utility Model Registration No. 20-0418998 (June 9, 2006)

### [Summary of Invention]

### [Technical Problem]

An object of the present invention is to provide a system for monitoring operation characteristics of a power switch, the system including an electrode sensor impregnated in the inside of a solid insulation material which is a component of a power switch, or an electrode sensor module that is separately provided outside to be separable/detachable, and being capable of monitoring and diagnosing, in real time, a status change of operation characteristics such as a switching time, time interval between the first pole and the last pole, stroke, or operating speed of each phase of the power switch in operation based on a characteristic that a voltage induced in a capacitance electrode sensor varies depending on a spatial position change of a movable electrode according to an operation of the switch, and outputting an alarm or a control signal for a lock if the operation characteristic of the power switch rapidly changed.

Another object of the present invention is to provide a system for monitoring operation characteristics of a power switch, the system being capable of easily monitoring and controlling the operation characteristics of the power switch even from a remote location since a communication module is mounted on the system to enable communication with an external computer at the remote location.

### [Solution to Problem]

A system for monitoring operation characteristics of a power switch according to a first embodiment of the present invention includes: capacitance electrode sensors that detect voltage induced during position movement of a movable electrode due to an operation of a circuit breaker by being installed to have circular, angular, and pin-type structures inside insulating partition spacers between a circuit breaker unit and a cable connection unit of an insulated switchgear;
capacitance electrode sensors that detect voltage induced during position movement of a movable electrode due to an operation of a three-stage switch (disconnect switch) by being installed to have circular, angular, and pin-type structures inside insulating partition spacers between the three-stage switch unit (disconnect switch unit) and the circuit breaker unit of a gas insulated switchgear; and
an integrated monitoring means that is connected to each of the electrode sensors, simultaneously operates, diagnoses and displays a switching time, time interval between the first pole and the last pole, stroke, and operating speed of each phase of a circuit breaker and the three-stage switch (disconnect switch) of the switchgear by converting and operating signals input from the electrode sensors into digital signals, and outputs an alarm or a control signal for locking if the operated output values deviate from the set range of operation characteristic limits.

A system for monitoring operation characteristics of a power switch according to a second embodiment of the present invention includes: capacitance electrode sensors that detect voltage induced during position movement due to vertical or rotational movement of main contact points of switching portions of a general switch by being installed to have circular, angular, and pin-type structures inside and outside an epoxy insulation housing provided outside the switching portions (vacuum interrupter and blade-shaped contact point) electrically connected to a primary inlet of the general switch; and
an integrated monitoring means that is connected to each of the electrode sensors, simultaneously operates, diagnoses, and displays a switching time, time interval between the first pole and the last pole, stroke, and operating speed of each phase of the general switch by converting and operating signals input from the electrode sensors into digital signals, and outputs an alarm or a control signal for locking if the operated output values deviate from the set range of operation characteristic limits.

A system for monitoring operation characteristics of a power switch according to a third embodiment of the present invention includes: electrode sensor modules that detect voltage induced during a switching operation of the power switch by being installed in a separable/detachable structure outside an insulating partition spacer constituting a gas partition wall of the power switch; and
an integrated monitoring means that is connected to each of the electrode sensor modules, simultaneously operates, diagnoses, and displays a switching time, time interval between the first pole and the last pole, stroke, and operating speed of each phase of the power switch by converting and operating signals input from the electrode sensor modules into digital signals, and outputs an alarm or a control signal for locking if the operated output values deviate from the set range of operation characteristic limits.

### [Advantageous Effects of Invention]

A system for monitoring operation characteristics of a power switch according to the present invention is capable of monitoring and diagnosing, in real time, the operation characteristics of the power switch to which voltage is applied in operation by installing electrode sensors having circular, angular, and pin-type structures impregnated in the inside a solid insulation material that is a component of the power switch or installing a separate separable/detachable detection electrode sensor modules on the outside.

The system for monitoring operation characteristics of a power switch according to the present invention is capable of displaying, in a form of a digital value and a graph in real time, an operation characteristics state such as a switching time, time interval between the first pole and the last pole, stroke, or operating speed of each phase of the power switch to which voltage is applied and which is in operation, monitoring an operation characteristic state of the power switch in real time at a remote location without making an inspector travel to the location at which the power switch is installed, performing alarm and locking control by outputting an alarm or a control signal for locking if the operation characteristics of the power switch rapidly changed, and performing replacement and maintenance of the power switch in a timely manner, thereby enabling an accident and accident spreading of a power system and power equipment to be prevented in advance to ensure operation reliability.

The system for monitoring operation characteristics of a power switch according to the present invention can be applied to asset management based on evaluation and analysis of integrity of the power equipment by accumulating, collecting, comparing, and analyzing data indicating the operation characteristics of the power switch, and the analyzed data not only can provide information which can be used to determine shutdown and maintenance of equipment to asset owners or managers thereof, but also can be used as information to issue an accurate work instruction to a field worker.

### [Brief Description of Drawings]

FIG. 1 is a structural view of a general three-phase integrated gas insulated switchgear.
FIG. 2A is a structural view of a three-stage switch unit of the general three-phase integrated gas insulated switchgear.
FIG. 2B is a structural view of a three-stage switch unit of a general phase-separated gas insulated switchgear.
FIG. 2C is a structural view of a circuit breaker unit of a general phase-separated gas insulated switchgear.
FIG. 3 is a structural view of a general solid insulated switch.
FIG. 4 is a conceptual diagram of a system for monitoring operation characteristics of a power switch according to the present invention.
FIG. 5A illustrates an example in which capacitance electrode sensors of the system for monitoring operation characteristics of a power switch according to the present invention are applied to the phase-separated gas insulated switchgear.
FIG. 5B illustrates an example in which the capacitance electrode sensors of the system for monitoring operation characteristics of a power switch according to the present invention are applied to a three-phase insulating partition spacer of the three-phase integrated gas insulated switchgear.
FIG. 5C illustrates an example in which the capacitance electrode sensors of the system for monitoring operation characteristics of a power switch according to the present invention are applied to the solid insulated switch.
FIG. 6A illustrates an example in which some (one in the case of the phase-separated type) mounting brackets (nut shape) of insulating partition spacers are substituted with impregnated and insulated pin-type electrodes to be directly used as capacitance electrode sensors in the system for monitoring operation characteristics of a power switch according to the present invention.
FIG. 6B illustrates an example in which some (one in the case of the phase-separated type) impregnated and insulated pin-type electrodes are additionally provided between mounting brackets (nut shape) of insulating partition spacers and are used as capacitance electrode sensors in the system for monitoring operation characteristics of a power switch according to the present invention.
FIG. 7A illustrates an example of a separable/detachable capacitance electrode sensor module of the system for monitoring operation characteristics of a power switch for applying the phase-separated gas-insulated switchgear according to the present invention.
FIG. 7B illustrates an example of a separable/detachable capacitance electrode sensor module of the system for monitoring operation characteristics of a power switch for applying the three-phase integrated gas insulated switchgear according to the present invention.
FIG. 8A is a diagram illustrating a potential distribution diagram and induced voltage of the electrode sensors when a three-stage switch of a gas insulated switchgear enters into an open (DS/ES open) state.
FIG. 8B is a diagram illustrating a potential distribution diagram and induced voltage of the electrode sensors when the three-stage switch of the gas insulated switchgear enters into a disconnect switch closed (DS close) state.
FIG. 8C is a diagram illustrating a potential distribution diagram and induced voltage of the electrode sensors when the three-stage switch of the gas insulated switchgear enters into an earth switch closed (ES close) state.
FIG. 9A is a graph illustrating a concept of measuring a switching time of each phase by using a change in induced voltage of the capacitance electrode sensors which appears when the three-stage switch unit of the gas insulated switchgear according to the present invention performs disconnect switch closing (DS close), disconnect switch opening (DS open), and earth switch closing (ES close) operations.
FIG. 9B is a graph illustrating a concept of measuring time interval between the first pole and the last pole at the time of a closing operation and time interval between the first pole and the last pole at the time of an opening operation according to operations of the three-stage switch unit of the gas insulated switchgear according to the present invention.
FIG. 10A is a diagram illustrating a potential distribution diagram and induced voltage of the electrode sensors when a circuit breaker of the gas insulated switchgear is in an opened state.
FIG. 10B is a diagram illustrating a potential distribution diagram and induced voltage of the electrode sensor when the circuit breaker of the gas insulated switchgear is in a closed state.
FIG. 11A is a graph illustrating a change in induced voltage of the capacitance electrode sensors depending on a gap between a fixed contact point and a movable contact point when the circuit breaker of the gas insulated switchgear according to the present invention operates from a closed state to an opened state.
FIG. 11B is a graph illustrating a concept of measuring an operation stroke and a speed of the circuit breaker when the circuit breaker of the gas insulated switchgear according to the present invention performs a switching operation in response to an operation command.
FIG. 12 is a schematic structural diagram illustrating a configuration of a monitoring means for monitoring operation characteristics such as a switching time, time interval between the first pole and the last pole, stroke, and operating speed of each phase of the power switch according to the present invention.

### [Description of Embodiments]

A system for monitoring operation characteristics of a power switch according to the present invention includes:
capacitance electrode sensors that are installed outside a primary side conductor of the power switch and detect electrostatic voltage induced during a main contact switching operation of the power switch; and
an integrated monitoring means for diagnosing operation characteristics for each phase based on the electrostatic voltage input from the capacitance electrode sensors and outputting an alarm or a control signal for locking if the operation characteristics deviate from the preset safety range of operation characteristics.

### [Embodiments]

The advantages and features of the present invention and methods for achieving the advantages and the features will become clarified by referring to the embodiments to be described below in detail along with the accompanying drawings. However, the present invention is not limited to the embodiments to be disclosed below and will be implemented in various different embodiments.

In the present invention, the present embodiments are provided to make the disclosure of the present invention complete and fully inform those skilled in the art of the scope of the invention. The present invention is only defined by the scope of the claims. Hence, in some embodiments, well-known constituent, well-known operations, and well-known technologies are not specifically described in order to avoid ambiguous interpretation of the present invention.

Similar reference numerals refer to similar constituent throughout the specification. Terms used (stated) in this specification are for describing embodiments and are not intended to limit the present invention. In this specification, a singular form also includes a plural form thereof unless specifically stated otherwise in the context. In addition, a constituent and an operation stated with 'to comprise (or, to include)' do not exclude presence or addition of one or more other constituents and operations.

Unless otherwise defined, all terms (including technical and scientific terms) used in this specification may be used to have respective meanings that can be commonly understood by those skilled in the art to which the present invention pertains. Additionally, terms defined in commonly used dictionaries are not interpreted ideally or excessively unless the terms are defined. Hereinafter, embodiments of the present invention will be described with reference to the accompanying drawings.

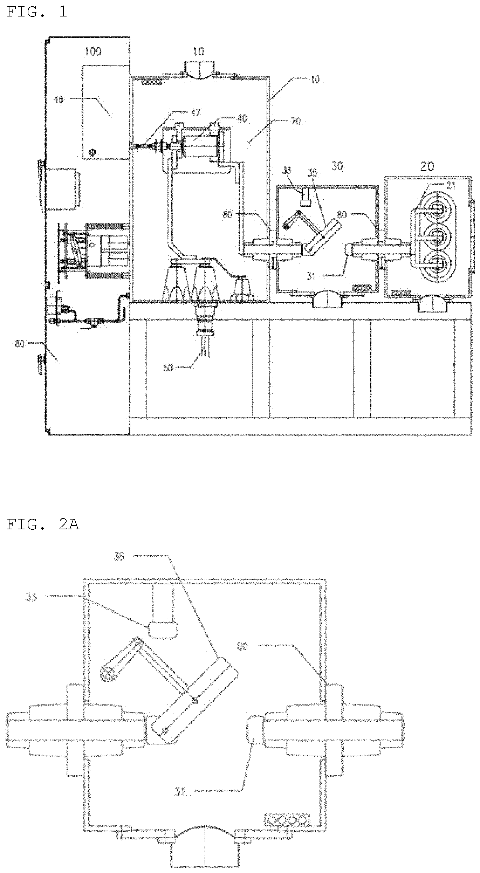

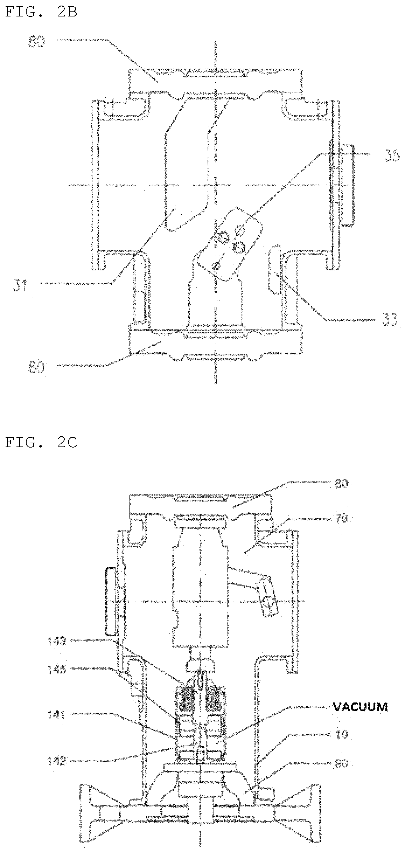

As illustrated in FIGS. 1, 2A, 2B, and 2C, a general gas insulated switchgear 100 includes an outer box 10 that forms a case, a bus bar unit 20 that includes a main bus bar 21 provided at an inner upper portion of the outer box 10 to connect a lead wire through which a high current flows and a support insulator supporting the main bus bar 21, a three-stage switch unit 30 that is formed to be divided by an insulating partition spacer 80 positioned on an inner upper side of the outer box 10 and includes a fixed electrode 31 connected to the main bus bar 21, an earth electrode 33 connected to earth, and a movable electrode 35 selectively connected to the electrodes, thereby fulfilling two functions of a disconnect switch (DS) enabling power lines to be disconnected from and connected to each other in a deenergized state and an earth switch (ES) used for an earth switching operation for maintenance and inspection, a circuit breaker unit 40 that is divided and formed at an inner central portion and protects a load device and power lines from a high fault current such as a short circuit or an earth fault that can occur in a circuit, a cable connection unit 50 to which a distribution line is connected, and a control panel 60 for operation, control, measurement, and monitoring of the gas insulated switchgear.

All electrically charged conductors positioned in the sealed outer box 10 of the gas insulated switchgear 100 are electrically insulated with insulating gas 70 filled therein, and constituents are formed to have respective gas sections separated from each other by the insulating partition spacers 80 to minimize the spread of an accident in any one constituent to another constituent. In addition, the metal outer box 10 is connected to an external ground portion and is maintained in an electrically grounded state, thereby ensuring operator safety during inspection and maintenance of the switchgear.

The circuit breaker unit 40 of the gas insulated switchgear 100 is formed to be divided in the outer box 10 of the gas insulated switchgear 100 filled with the insulating gas 70 and is interposed between the three-stage switch unit 30 and the cable connection unit 50 to protect the load device and power lines from a fault current. The circuit breaker units are classified into a vacuum circuit breaker, a gas circuit breaker, and the like depending on an arc-quenching medium which is generated during switching and interrupting. In general, in a transmission voltage level (level of 154 kV or higher), gas circuit breakers using SF₆ gas as the arc-quenching medium are often used, and in a distribution voltage level having a rated voltage lower than the transmission voltage, vacuum interrupters having excellent arc-quenching and insulation performance are often used.

As illustrated in FIG. 2C, in the case of the circuit breaker unit 40 of the gas insulated switchgear including a vacuum interrupter, a fixed electrode portion 142 and a movable electrode portion 143 are coaxially arranged in a cylindrical ceramic insulating tube 141 having a vacuum sealed inside, and the circuit breaker unit 40 includes a shielding plate 145 that is attached to an inner wall of ceramic insulating tube 141 to prevent insulation performance of the insulating tube 141 from deteriorating by metallic ions released during arc generation due to switching operation of a contact point adhering thereto.

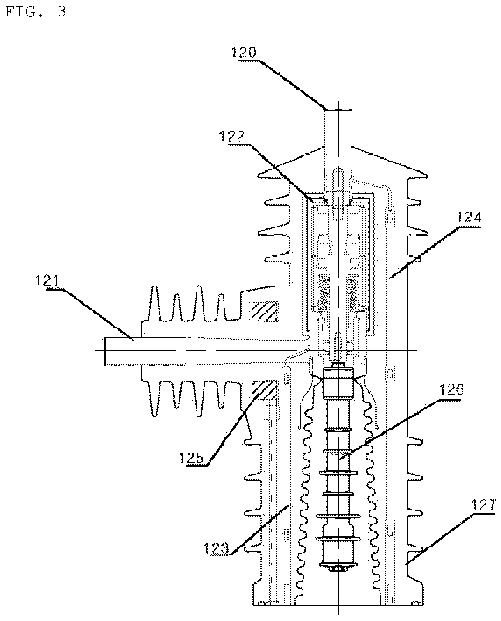

The circuit breaker unit 40 configured of a solid insulated switch illustrated in FIG. 3 largely includes an epoxy insulation housing 127 molded with a polymer, a vacuum valve 122 bound to an inside of the polymer epoxy insulation housing 127 by molding, an insulating rod 126 connecting the vacuum interrupter to an manipulator (not illustrated), a primary side conductor 121 for electrical connection to a power source side, a secondary side conductor 120 for electrical coupling and connection to a load side, a wire-wound current transformer 125 for measuring a load current, and a primary side voltage detection sensor 123 and a secondary side voltage detection sensor 124 for detecting voltage. A switching operation of the solid insulated switch is performed by a manual operation using a manual operation handle and an electrical operation using an electric motor. Clockwise or counterclockwise rotational power generated by the electric or manual operation is transmitted to a power transmission device (not illustrated) through a drive shaft (not illustrated). The power transmission device converts the clockwise or counterclockwise rotation power into switching drive force in a vertical direction and transmits the switching drive force to an insulating rod 246, so that a main contact of a lower switch is driven to perform the switching operation.

Since a power system is configured of the three-phase AC to efficiently supply electrical energy, all items of electrical equipment such as switchgear and general switch used in the system are also configured of the three-phase AC. In general, a power switch used in a power system performs a switching operation through a simultaneous three-phase operation of the movable electrode 35 by a single manipulator provided in an external control panel. Main elements of operation characteristics for evaluating performance of a power switch are a switching time, time interval between the first pole and the last pole, stroke, and operating speed of each phase of the power switch.

A power switch that is switched(open/closed) on site or from a remote location with a communication means needs to complete a switching operation within a determined switching time when a switching manipulation signal is received, and at the same time, the switching operation should not exceed the time interval between the first pole and the last pole specified in standards. The time interval between the first pole and the last pole of the power switch refers to a difference between operation times of respective phases of the power switch due to link lengths of respective phases in the case of a three-phase integrated operation of the power switch, an assembly tolerance in assembling mechanical manipulator components such as a lever, a shaft, or a rod, and an electrical or mechanical defect which occurs during an operation. When a difference between the switching times of respective phases is very large, the power switch can enter into a state where it is not possible to perform the switching (interrupting), and thus it is necessary to continuously monitor and diagnose the difference.

Before the power switch is applied to the power system, performance of the power switch is verified in advance by determining the lower and upper limits of a size of control power in a development test and measuring operation characteristics such as a switching time, time interval between the first pole and the last pole, stroke, and operating speed. However, it is difficult to diagnose operation characteristics due to an electrical or mechanical defect during operation since the power switch is continuously used after being applied to the power system. As countermeasure thereof, the Korea Electric Power Corporation currently performs maintenance of power switches by measuring the operation characteristics in an operation stop state in which voltage is not applied according to short-term, medium-term, and long-term inspection schedules in accordance with operating guidelines.

In a case where a main contact of the power switch is severely worn due to long-term use, the insulation performance of the switch can deteriorate and the operation characteristics may change. Additionally, due to an increase in main circuit resistance, heat generation from a charging conductor increases, which can adversely affect basic physical or chemical properties of an insulating material around the charging conductor. In addition, this can result in insufficient pressure between contacts, and thereby an electrode may be displaced from a normal position thereof due to an electromagnetic force generated when a large current is applied. This can lead to a major electrical accident. Hence, it is necessary to apply a technology that can monitor and diagnose states of the operation characteristics in real time during switching of the power switch even in an operation period in which voltage is applied, as well as inspection in a power cut state.

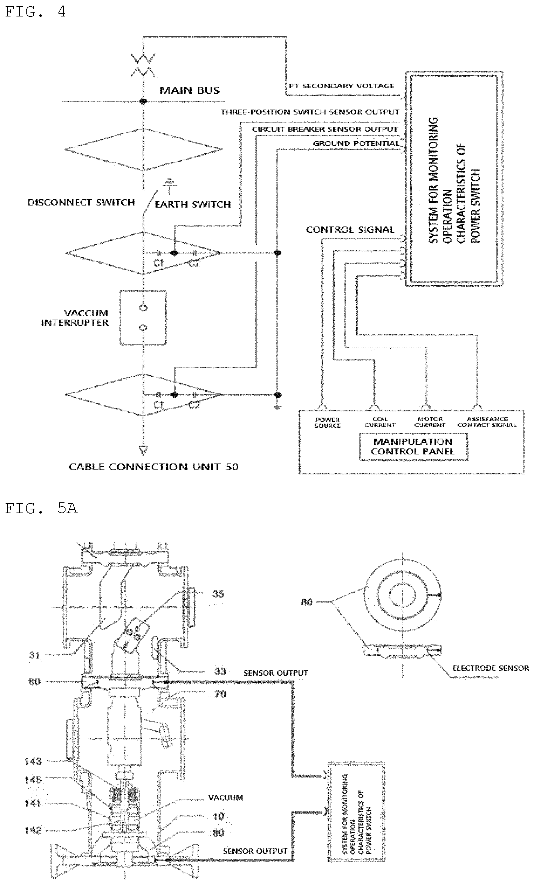

As illustrated in FIG. 4, a system for monitoring operation characteristics of a power switch according to the present invention measures and calculates operation characteristics such as an switching time, time interval between the first pole and the last pole, stroke, and operating speed of each phase of the power switch in real time in a pressurizing operation state and outputs an alarm or a control signal for locking if the measured values deviates from a preset safety range. In this manner, an alarm is output to the outside by an alarm means such that a manager can take action, or an operation of the power switch can be automatically inhibited by a locking means to prevent serious accidents due to an electrical or mechanical abnormality of the power switch, in advance.

A capacitance electrode sensor unit for the system for monitoring operation characteristics of a power switch is installed in a form of an electrode sensor module having an electrode sensor structure including electrodes impregnated in an insulation material of the insulating partition spacer 80 of the switch or having a structural characteristic of separation/detachment to the outside of the insulating partition spacer in the power switch, and is configured of a combined circuit of capacitances C1 and C2 which are formed electrically sequentially between a main conductor and an electrode sensor, and the electrode sensor and the outer box of the power switch. Hence, a status change of the operation characteristics such as a switching time, time interval between the first pole and the last pole, stroke, or operating speed of each phase of the power switch in operation can be monitored using the characteristic that a voltage induced by the capacitance electrode sensors varies when the position of the movable electrode 35 is spatially changed in response to a control instruction.

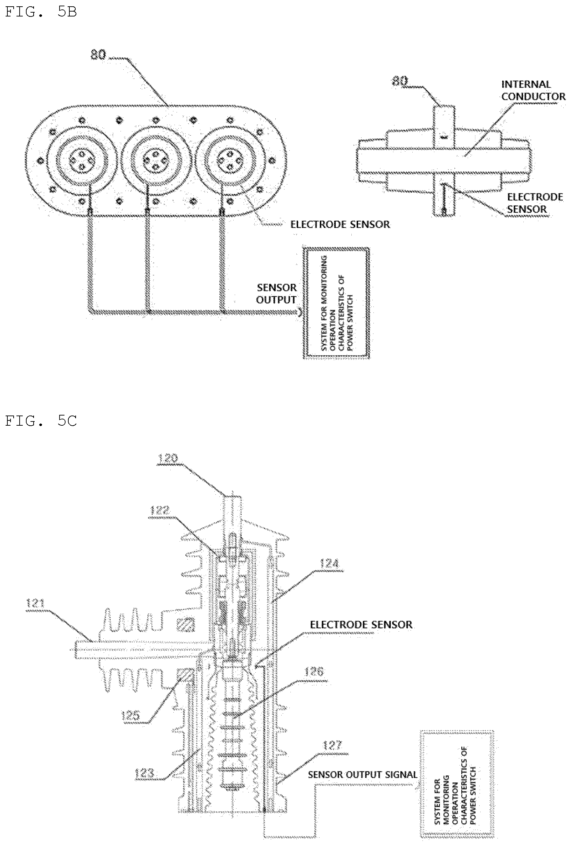

As illustrated in FIGS. 5A, 5B, and 5C, the internal electrode sensors installed in the form of being impregnated in an insulation material to monitor and diagnose the operation characteristics of the power switch can be configured in various forms depending on a type and structure of power switch.

As illustrated in FIG. 5A, in the system for monitoring operation characteristics of a power switch, such as a phase-separated gas insulated switchgear, electrode sensors for a three-stage switch are installed for respective phases in forms of ring-shaped or angular conductors inside the single-phase insulating partition spacer 80 between the three-stage switch unit 30 and the circuit breaker unit 40, and electrode sensors for the circuit breaker are installed for respective phases in a form of a ring-shaped or angular conductor inside the single phase blocking insulating partition spacer 80 between the circuit breaker unit 40 and the cable connection unit 50. As illustrated in FIG. 5B, for the system for monitoring operation characteristics of a power switch, such as a three-phase integrated gas insulated switchgear, the electrode sensors are arranged in an integrated structure in which three ring-shaped or angular conductors are positioned inside in one three-phase insulating partition spacer 80 between the three-stage switch unit 30 and the circuit breaker unit 40 and between the circuit breaker unit 40 and the cable connection unit 50. As illustrated in FIG. 5C, in the system for monitoring operation characteristics of a power switch, such as a solid insulated switch, the electrode sensors can be installed in forms of ring-shaped or angular conductors inside an external epoxy insulation housing 127 in which switching portions (a vacuum interrupter and a blade-shaped contact) that are electrically connected to a primary side inlet 121 of the switch is impregnated.

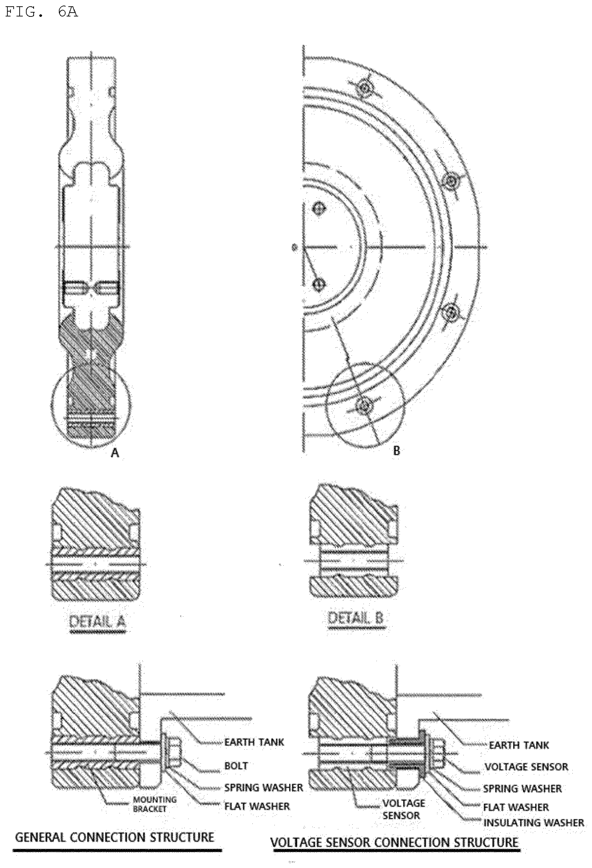

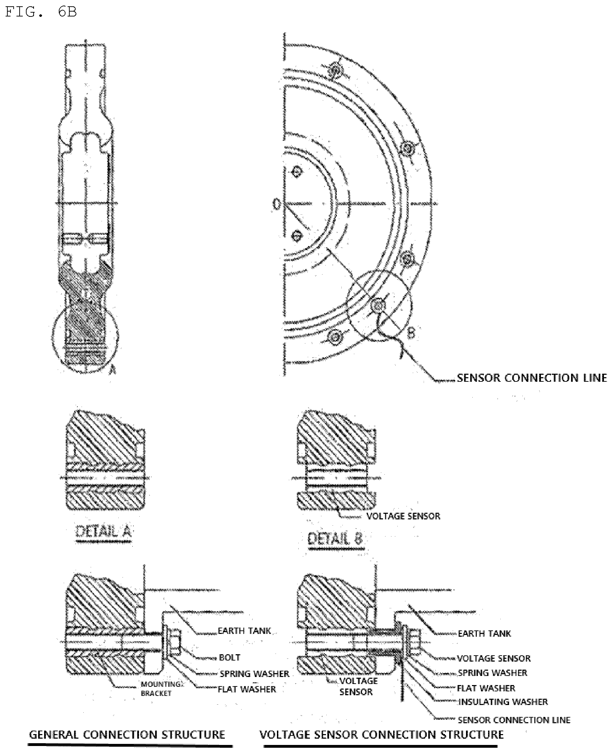

In the system for monitoring operation characteristics of a power switch, such as the phase-separated gas insulated switchgear, as illustrated in FIG. 6A, one of mounting brackets (nut shape) of an existing insulating partition spacer 80 can be insulated and can directly be used as a capacitance electrode sensor, or as illustrated in FIG. 6B, one impregnated and insulated pin-type electrode can be added between the mounting brackets (nut shape) of the insulating partition spacer to be used as the capacitance electrode sensor. Similarly, in the system for monitoring operation characteristics of a power switch, such as the three-phase integrated gas insulated switchgear, three brackets of mounting brackets (nut shape) of an insulating partition spacer adjacent to main conductors of respective phases can be insulated by the same method and can directly be used as capacitance electrode sensors of respective phases, or three impregnated and insulated pin-type electrodes can be added between the mounting brackets (nut shape) of the insulating partition spacer to be used as the capacitance electrode sensors of the respective phases.

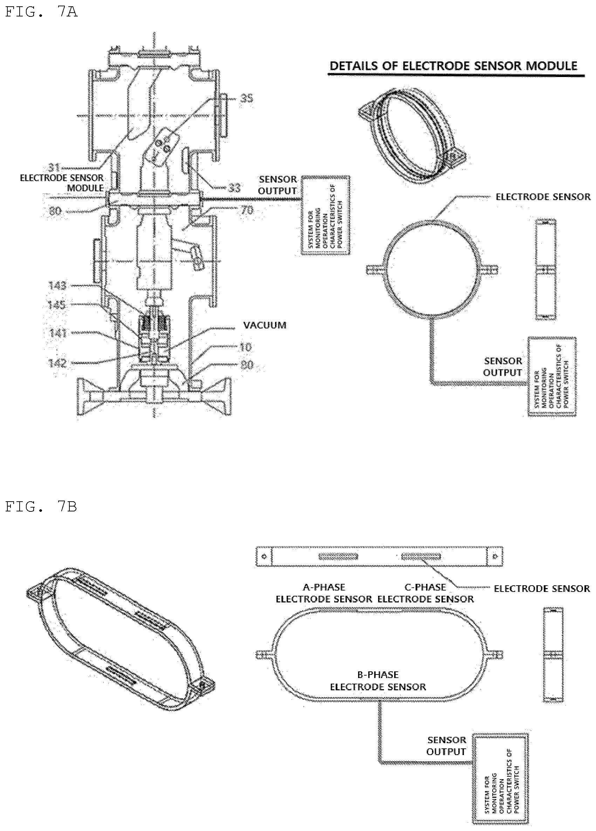

As illustrated in FIGS. 7A and 7B, the detachable electrode sensor module unit for monitoring and diagnosing operation characteristics of a power switch includes electrode sensors of respective phases installed in a ring structure that is detachable outside the insulating partition spacer without changing a structure of the power switch and has structural features enabling to be additionally installed and applied not only to a newly applied switchgear but also to an existing switchgear easily.

As described above, the system for monitoring operation characteristics of a power switch according to the present invention includes: the capacitance electrode sensors and the electrode sensor module for voltage detection, which are configured in various forms depending on a type of power switch; and monitoring means that are connected to the electrode sensors, respectively, simultaneously operate, diagnose, and display switching times, time interval between the first pole and the last pole, stroke, and operating speed of each phase of the power switch by converting and operating signals input from the electrode sensors into digital signals, and can output an alarm or a control signal for locking if the operated output values deviate from the set range of operation characteristic limits. Hence, replacement and maintenance of the power switch can be performed in a timely manner, and accidents of a power system and a power device can be prevented in advance such that drive reliability of the system can be ensured.

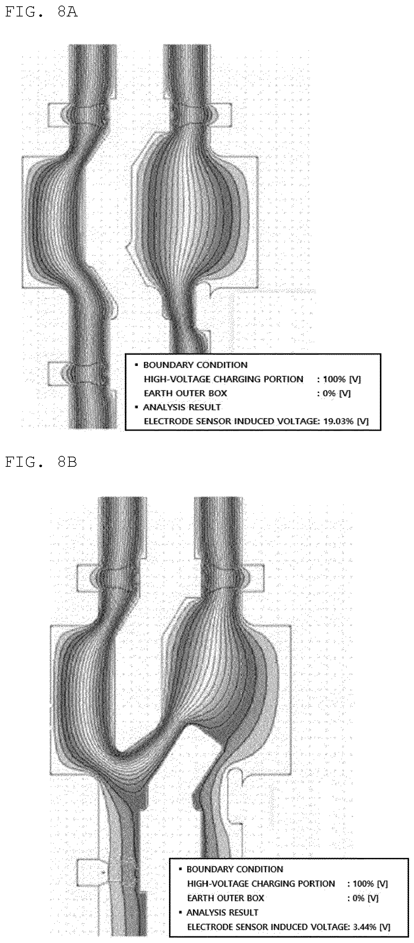

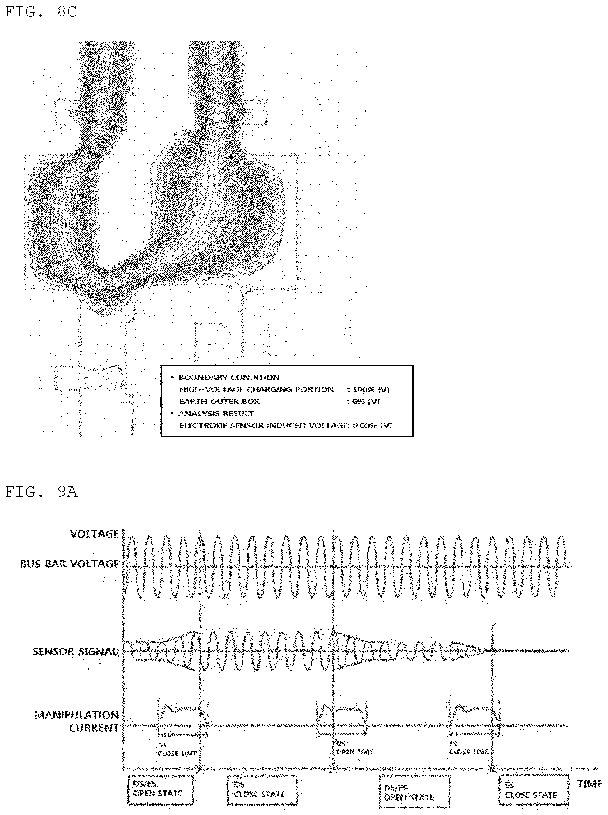

FIGS. 8A, 8B, and 8C illustrate potential distributions of the three-stage switching units of the gas insulated switchgears using the finite element method and the induced voltage of the electrode sensor according to the present invention, respectively, and show that values of the voltage induced by the capacitance electrode sensors are different depending on changes in spatial positions of the movable electrodes according to operations of the switch in the case of an opened (DS/ES Open) state of the three-stage switch of the gas insulated switchgear (FIG. 8A), in the case of a closed (DS Close) state of a disconnect switch (FIG. 8B), and in the case of a closed (ES Close) state of an earth switch (FIG. 8C). When V_{OPEN} represents the induced voltage in the case of the opened state of the three-stage switch, V_{DSCL} represents the induced voltage in the case of the closed state of the disconnect switch, and V_{ESCL} represents the induced voltage in the case of the closed state of the earth switch, as illustrated in the drawings, V_{DSCL} = 19.03% [V], V_{OPEN} = 3.44% [V], V_{ESCL} = 0.00% [V] . The respective values of V_{DSCL}, V_{OPEN}, and V_{ESCL} are provided as examples and are not necessarily limited thereto, but have a relationship of V_{DSCL}> V_{OPEN}> V_{ESCL}. Hence, it can be verified that a switching time of the three-stage switch can be measured from a change in the induced voltage of the electrode sensor that occurs due to a change in internal capacitance according to position movement of the movable electrode.

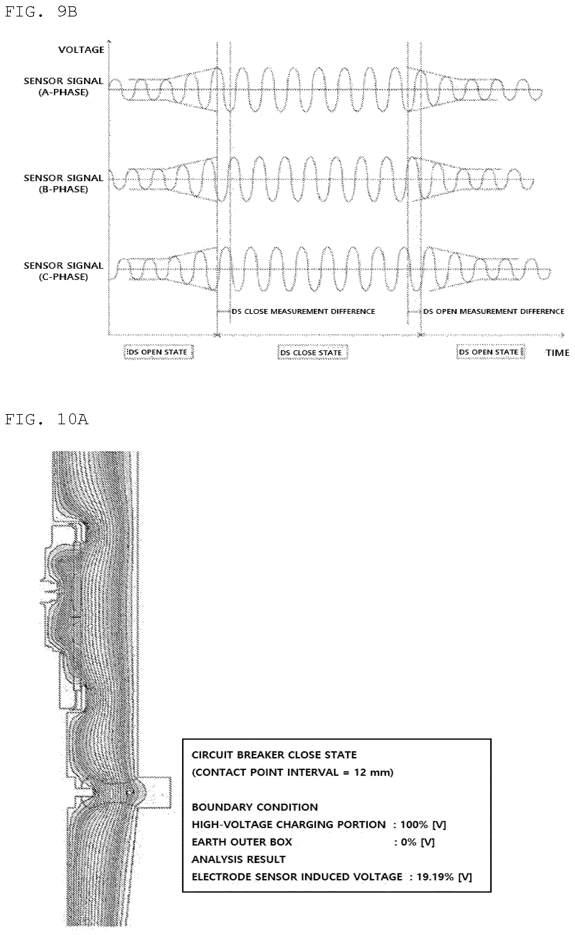

FIG. 9A illustrates a basic concept of measuring a switching time of each phase by using a change in induced voltage of the capacitance electrode sensors which occurs when the three-stage switch unit of the gas insulated switchgear according to the present invention performs disconnect switch closing, disconnect switch opening, or earth switch closing operations. FIG. 9B is a graph illustrating a concept of measuring time interval between the first pole and the last pole at the time of a closing operation and time interval between the first pole and the last pole at the time of an opening operation according to operations of the three-stage switch unit of the gas insulated switchgear.

When the three-stage switch of the gas insulated switchgear is in the opened (DS/ES Open) state and a command to close the disconnect switch is transmitted by a controlling switch, a motor for the manipulator is driven, force is transmitted through an external link interconnected with the movable electrode 35, and the movable electrode of the power switch is moved from an opened position to a closed position of the disconnect switch. At this time, a manipulation current of the motor for the manipulator of the power switch changes until the operation of the movable electrode 35 is completed, as illustrated in FIG. 9A. When the position of the movable electrode is changed, values of the capacitance C1 between the pressurized and charged bus bar 21 and the electrode sensor, and the capacitance C2 between the electrode sensor and the earth outer box are changed. The voltage induced by the electrode sensor is increased from a voltage V_{OPEN} value of the electrode sensor in the opened position, and when a disconnect switch closing operation is completed, the voltage induced by the electrode sensor converges to the constant voltage value V_{DSCL}. When the power switch located at a disconnect switch closed position receives a disconnect switch open command, the same electrical and mechanical operation processes are executed. At this time, voltage induced by the electrode sensor is decreased from the V_{DSCL} value to the V_{OPEN} value, as opposed to the case where the disconnect switch is closed, and finally the induced voltage converges to a constant value. In addition, closing and opening operations of the earth switch proceed through similar processes as above. During the closing operation of the earth switch, the induced voltage of the electrode sensor is decreased from V_{OPEN} to V_{ESCL} (= 0 V), and during the opening operation of the earth switch, the induced voltage is increased from V_{ESCL} to V_{OPEN}.

As illustrated in FIG. 9A, the system for monitoring operation characteristics of the three-stage switch of the gas insulated switchgear, which is an application example according to the present invention, can monitor switching times of respective phases in real time in a pressurized operation state from a change in induced voltage of the electrode sensor installed for each phase and time interval between the first pole and the last pole during the opening operation of the three-stage switch can be calculated and diagnosed by comparing and analyzing a difference in opening and closing time between phases as illustrated in FIG. 9B. The system for monitoring operation characteristics of a power switch of the three-stage switch according to the present invention can preemptively take action of maintenance by monitoring and diagnosing the electrical and mechanical abnormalities of the three-stage switch of the power switch all the time by comparing operation characteristics data collected in real time with reference operation characteristics data in a normal condition.

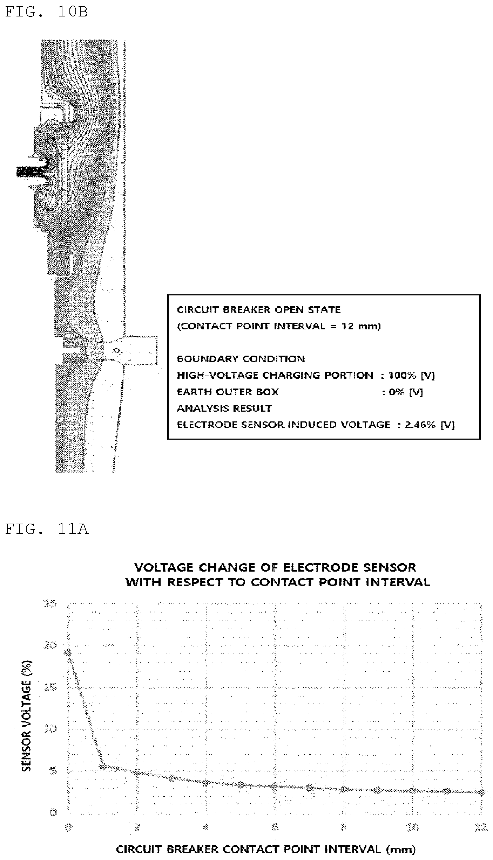

FIGS. 10A and 10B illustrate a potential distribution of the circuit breaker unit of the gas insulated switchgear using a vacuum interrupter and the induced voltage of the electrode sensor according to the present invention which is obtained by the finite element method. Regarding the voltage induced by the capacitance electrode sensor depending on a change in spatial position of the movable electrode 35 according to an operation of the circuit breaker in the cases of the circuit breaker closed (CB close) state and the circuit breaker opened (CB open) state of the gas insulated switchgear, it can be verified that voltage (19.190 [V]) induced by the electrode sensor at the circuit breaker closed position is larger than voltage (2.46% [V]) induced at the circuit breaker opened position. The induced voltage (19.19% [V]) of the electrode sensor at the circuit breaker closed position and the induced voltage (2.46% [V]) at the circuit breaker opened position are provided as examples thereof and are not necessarily limited to these values. The switching times of respective phases and the time interval between the first pole and the last pole during the switching operation of the circuit breaker can be measured from a change in induced voltage of the electrode sensor in the same method as that applied to the three-stage switch unit of the gas insulated switchgear, and the stroke and the operating speed can also be measured and diagnosed online in real time.

FIG. 11A is a graph illustrating a change in induced voltage of the capacitance electrode sensors in a case where a gap between a fixed contact point and a movable contact point is changed by 1 mm when the circuit breaker of the gas insulated switchgear according to the present invention operates from a closed state to an opened state.

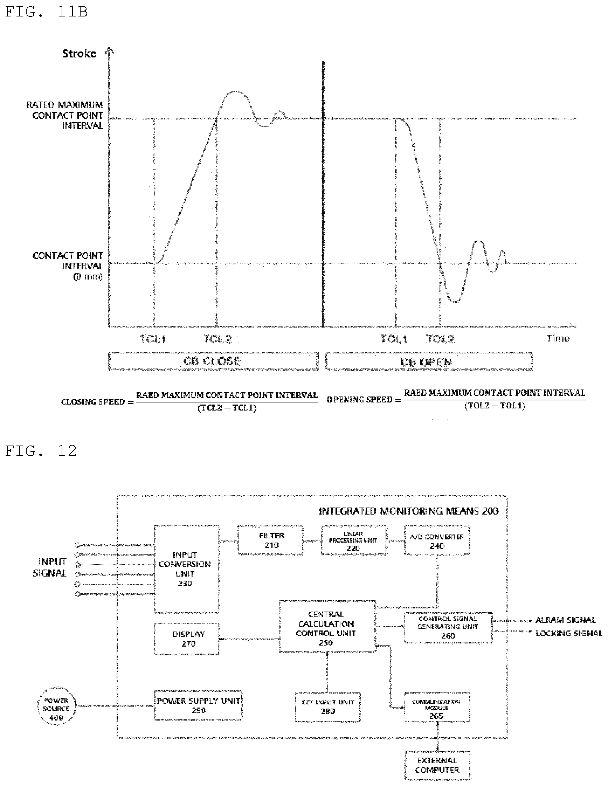

FIG. 11B is a graph illustrating the concept of measuring an operation stroke of the circuit breaker based on the change in induced voltage of the electrode sensor of FIG. 11A, and is a graph obtained by considering and estimating electrical and mechanical characteristics of a manipulation device depending on a temporal change when the circuit breaker of the gas insulated switchgear receives a command and completes a switching operation. In a circuit breaker that uses a spring charging-type manipulator, which is often used in the Korean distribution voltage level, an input spring is compressed by a cam and a crank connected to an electric motor when control power is applied. At this time, when a closing command is received, a closing coil operates by excitation of the closing coil and the input spring is decompressed, a manipulation shaft is rotated by movement of a roller connected to the manipulation shaft, and a closing operation is performed rapidly. During the closing operation, an opening spring is simultaneously compressed, and after the operation, a pressure force at a contact point of the circuit breaker is maintained by a wipe spring that is mechanically connected to the manipulation shaft. Regarding the opening operation, when an opening command is received, a rod is operated by excitation of an opening coil, and the manipulation shaft is rotated due to restoring forces of the opening spring and wipe spring, causing the circuit breaker to perform a rapid opening operation within a very short time. As illustrated in a stroke curve of FIG. 11B, transmission of force in an initial switching operation is delayed due to a time taken in a process of transmitting forces of a cam, a lever, a shaft, a rod, or the like constituting the manipulation device when performing the switching operation by the excitation of the coil. The stroke curve obtained by using the induced voltage also show an oscillation pattern due to changes in intervals between contact points because of the generation of mechanical oscillation during the switching operation due to an impact of various springs used in a mechanical manipulation device and a contact point repulsion force. By using digital data of the switching time of each phase and the stroke curve obtained as described above based on pre-input circuit breaker contact point intervals, an average switching speed and an initial switching speed of the circuit breaker of the gas insulated switchgear can be monitored, diagnosed, and displayed in real time.

By this method, the system for monitoring operation characteristics of a power switch according to the present invention is widely applicable to every power switch using a method of switching by a structure in which contact points are separated and moved, such as a switchgear and a circuit breaker, a load breaker switch, an automatic transfer switch, an automatic section switch, an automatic load transfer switch, a disconnect switch, and the like which are general switches.

As illustrated in FIG. 12, an integrated monitoring means 200 includes: an input conversion unit 230 that converts voltage of a potential transformer (PT) and signals input from capacitance electrode sensors for detecting secondary side reference voltage into voltage values; an A/D converter 240 that converts the voltage values received from the input conversion unit 230 into digital signals; a central operation control unit 250 that is connected to the A/D converter 240 and operates and diagnoses operation characteristics such as a switching time, time interval between the first pole and the last pole, stroke, operating speed of each phase of a power switch based on the digital signals input through the A/D converter 240; a control signal generating unit 260 that is connected to the central operation control unit 250 and outputs an alarm or a control signal for locking if an operation characteristic value of the power switch diagnosed by the central operation control unit 250 deviates from a set safety range of operation characteristics; a display 270 that is connected to the central operation control unit 250 and digitally displays each switching state of the power switch operated and diagnosed by the central operation control unit 250; a key input unit 280 that is connected to the central operation control unit 250 and enables setting of an operation mode or a safety range; and a power supply unit 290 that supplies power for an operation from an external power source 400.

The A/D converter 240 is connected to the input conversion unit 230. This A/D converter 240 converts the voltage value received from the input conversion unit 230 into a digital signal and transmits the digital signal to the central operation control unit 250 that functions as a digital operation device.

The central operation control unit 250 connected to the A/D converter 240 is a type of central operation processing unit that operates and diagnoses operation characteristic values of the power switch for each phase based on the digital signals input through the A/D converter 240, transmits the operation characteristic values to the display 270, and provides a signal to the control signal generating unit 260 if the operated operation characteristic values deviate from the preset safety range, and sets an operation mode or a safety range of operation characteristic value in advance in response to an input signal input from the key input unit 280. The central operation control unit 250 is implemented in a form of a printed circuit board having a predetermined circuit printed thereon or a chip with predetermined circuits integrated thereon.

The control signal generating unit 260 connected to the central operation control unit 250 outputs an alarm or a control signal for locking if the operation characteristic values operated and diagnosed by the central operation control unit 250 deviates from the preset safety range due to an electrical or mechanical defect, thereby enabling a manager to take appropriate action by outputting an alarm sound to the outside through a predetermined alarm means (not illustrated) connected to the control signal generating unit 260, or enabling an operation of the power switch to be automatically interrupted by a predetermined locking means (not illustrated) connected to the control signal generating unit 260.

The control signal generating unit 260 includes a control signal output terminal that is installed on a rear surface of the integrated monitoring means 200 and outputs an alarm or a control signal for a lock, and the above-described alarm means and locking means are electrically connected to this control signal output terminal.

The display 270 connected to the central operation control unit 250 digitally displays the operation characteristic values of the power switch of each phase operated and diagnosed by the central operation control unit 250, and can include a panel that displays, as numeric values and graphs, operation characteristics such as switching time, time interval between the first pole and the last pole, stroke, and operating speed of each phase of the power switch, a safety range display window on which a safety range and an upper and lower danger range are continuously displayed, and two operation display lamps (not illustrated) that are installed on a front side of the integrated monitoring means 200 and display whether the alarm or the control signal for locking is output by the control signal generator 260, but the display is not necessarily limited thereto.

The key input unit 280 connected to the central operation control unit 250 enables setting of the operating mode or a safety range of operation characteristic values, and can include a mode selection button that enables setting of the operating mode and a safety range setting button that enables setting of the safety range of operation characteristic values.

The power supply unit 290 supplies power for an operation from the external power source 400 and includes a power connection terminal (not illustrated) to which the external power source 400 is connected as illustrated in FIG. 8. It is preferable that the external power source 400 be DC voltage for a stable operation of the integrated monitoring means 200.

A communication module 265 connected to the central operation control unit 250 enables communication to be performed with an external computer at a remote location such that monitoring of an operation characteristic status of the power switch can be performed through the external computer at the remote location, and it is preferable that the communication module be configured of a known wireless communication module such as Bluetooth or a known wired communication module such as a modem.

In addition, the integrated monitoring means 200 can also further include a filter 210 that is sequentially connected between the input conversion unit 230 and the A/D converter 240 and removes noise from the voltage value output from the input conversion unit 230, and a linear processing unit 220 that linearizes the voltage value having passed through the filter 210 and provides the linearized value to the A/D converter 240.

Since abnormal voltage due to magnetic fields and switching surges can be included in a power switch operated in a state in which high voltage is applied, the filter 210 is installed to remove the abnormal voltage, and it is desirable that the filter 210 be configured of a low-pass filter.

## Claims

1. A system for monitoring operation characteristics of a power switch, comprising:
capacitance electrode sensors that are installed outside a primary side conductor of the power switch and detect electrostatic voltage induced during a main contact switching operation of the power switch; and
an integrated monitoring means for diagnosing operation characteristic for each phase based on the electrostatic voltage input from the capacitance electrode sensors and outputting an alarm or a control signal for locking if the operation characteristics deviate from the set safety range of operation characteristics.

2. The system for monitoring operation characteristics of a power switch according to claim 1,
wherein, in a case where a main contact point of the power switch operates a switching operation, the voltage induced in the electrode sensor changes due to a partial pressure characteristic generated by a relative change in internal capacitance of the electrode sensor of the power switch.

3. The system for monitoring operation characteristics of a power switch according to claim 1,
wherein the capacitance electrode sensors include a combined circuit of capacitances (C1 and C2) that are sequentially electrically formed between the primary side conductor and the electrode sensor, and the electrode sensor and a ground electrode.

4. The system for monitoring operation characteristics of a power switch according to claim 1,
wherein the capacitance electrode sensors are noncontact sensors and are configured of
circular, angular, and pin-type electrode sensors impregnated inside an insulation material in inner spaces of insulating partition spacers between a circuit breaker unit and a 3-stage switch unit and between the 3-stage switch unit and a busbar unit,
circular, angular, and pin-type electrode sensors inside and outside an epoxy insulating housing of the circuit breaker unit, or
an electrode sensor module that is separable/detachable on the outside the insulating partition spacer and the insulating material.

5. The system for monitoring operation characteristics of a power switch according to claim 1,
wherein operation characteristics diagnosed based on the capacitance electrode sensors include a switching time, time interval between the first pole and the last pole, stroke, and operating speed of each phase of the power switch.

6. The system for monitoring operation characteristics of a power switch according to claim 1,
the integrated monitoring means receives, from a manipulation control panel, operation and control signals including secondary voltage of a potential transformer (PT), control power, a coil current, a motor current, or assistance contact signal of the power switch.

7. The system for monitoring operation characteristics of a power switch according to claim 1,
wherein the integrated monitoring means includes
an input conversion unit that converts signals input from a potential transformer (PT) and electrode sensors into voltage values,
an A/D converter that is connected to the input conversion unit and converts the voltage values received from the input conversion unit into digital signals,
a central operation control unit that is connected to the A/D converter and diagnoses a switching operation of a switching device of each phase based on digital signals input through the A/D converter,
a control signal generating unit that is connected to the central operation control unit and outputs an alarm of a control signal for a lock if a switching state of the switching device diagnosed by the central operation control unit deviates from a preset safety range,
a display that is connected to the central operation control unit and digitally displays the switching state of the switching device diagnosed by the central operation control unit,
a key input unit that is connected to the central operation control unit and is capable of setting an operation mode or a safe vacuum level range, and
a power supply unit that is provided in the integrated monitoring means to supply power for an operation of the integrated monitoring means from an external power source.

8. The system for monitoring operation characteristics of a power switch according to claim 7,
wherein the integrated monitoring means further includes
a communication module that is connected to the central operation control unit and enables communication with an external computer at a remote location to enable operation characteristics including a switching time, time interval between the first pole and the last pole, stroke, or operating speed of each phase of the power switch to be monitored through the external computer at the remote location.

9. The system for monitoring operation characteristics of a power switch according to claim 1,
wherein the power switch includes a gas insulated switchgear having a switching method using a contact point, a solid insulated switchgear, a circuit breaker, a load breaker switch, an automatic transfer switch, an automatic section switch, an automatic load transfer switch, an earth switch, or a disconnect switch.
